Europäisches Patentamt

European Patent Office

Office européen des brevets

(19)

(11) Publication number: **0 125 076 B1**

(12) **EUROPEAN PATENT SPECIFICATION**

(45) Date of publication of patent specification: **30.07.86**

(21) Application number: **84302839.0**

(22) Date of filing: **27.04.84**

(51) Int. Cl.⁴: **C 03 C 3/14,** H 01 C 7/00, H 01 B 1/16, H 05 K 1/09

(54) Glass frit composition and ink containing it.

(30) Priority: **02.05.83 US 490258**

(43) Date of publication of application: **14.11.84 Bulletin 84/46**

(45) Publication of the grant of the patent: **30.07.86 Bulletin 86/31**

(84) Designated Contracting States: **BE DE FR GB NL SE**

(56) References cited:
GB-A-1 544 794
US-A-4 433 269

Kirk-Othmer, Encyclopedia of Chemical Technology, 3rd Edition Volume 9 page 4

(73) Proprietor: BURROUGHS CORPORATION (a Michigan corporation) Burroughs Place Detroit, Michigan 48232 (US)

(72) Inventor: **Braude, Ruvim** 610 Salem Avenue, B5 Elizabeth New Jersey 07208 (US)

(74) Representative: **Kirby, Harold Douglas Benson et al** G. F. Redfern & Company Marlborough Lodge 14 Farncombe Road Worthing West Sussex BN11 2BT (GB)

# 0 125 076

**Description**

Background of the Invention

An improved ink for use in preparing conductors in gas discharge display devices is described in US—A—4 433 269. The ink described in that Patent Specification contains aluminum and operates satisfactorily; however, for some applications, the ink requires a darker color, greater adherence to a glass substrate, and greater conductivity. The present invention provides an improved glass frit which can be combined with other elements including aluminum to provide an improved screenable ink having improved characteristics.

GB—A—1 544 794 also discloses a conductor composition comprising aluminium and glass. In this case the composition includes silicon.

Glass formulations comprising a major fraction of PbO and a minor fraction of $B_2O_3$ are also known for use as enamels (see for example Kirk-Othmer Encyclopedia of Chemical Technology, Third edition, Volume 9, page 4).

Description of the Invention

The formulation of the glass frit of the invention includes the following components with the indicated optimum weight percentages and permissible variations:

|  | Optimum Weight % | Permissible Variations in Weight % |
|---|---|---|
| PbO | 76 | ±6 |
| $B_2O_3$ | 15 | ±4 |
| $Cr_2O_3$ | 1 | up to 3 |
| $Fe_2O_3$ | 3 | 0.5—4 |
| CuO | 5 | 1.5—7 |

The glass frit is prepared by mixing all of the above components, heating for a suitable period of time, and then cooling to form the glass. It can then be ground to form a powder or stored in any other suitable form.

The glass frit of the invention is particularly suited for use in preparing a conductive ink, such as an aluminum ink of the type used for forming reinforcing conductors around transparent anodes in a cold cathode gas discharge display device by a screening process. An ink of this type is disclosed in the above-mentioned application. The glass formulation of the invention, as a constituent of an aluminum-containing conductive thick film ink, makes the ink especially suited for screening conductors on a soda-lime glass support plate. The glass imparts to the ink a dark, opaque color at the interface of the glass substrate and the fired coating which is desirable because it prevents light reflections. The glass also improves conductivity, and it provides optimum adhesion of the fired ink to a soda-lime substrate.

This glass formulation of the invention is high in lead to provide a low melting temperature, and the combination of CuO and $Fe_2O_3$ gives the glass completely dark and opaque color and improves conductivity of the final thick film composition. The $Cr_2O_3$ prevents $Cu^{-2}$ reduction from the glass melt.

This glass formulation does not contain inert fillers as a means of obtaining dark colors. An aluminum ink made with the glass frit of the invention includes all of the constituents disclosed in US—A—4 433 269 except that the glass is replaced with the glass described above. The ink utilizes aluminum as an important component and includes nickel powder, aluminum powder, aluminum/silicon alloy powder, the glass of the invention as a binder, and a vehicle. The nickel powder has an average particle size of about one micrometre; the aluminum powder has an average size of about three micrometres; and the aluminumsilicon alloy powder has a particle size in the range of five to ten micrometres. One suitable aluminum/silicon alloy is Valimet's H—10, which is a blackish gray, spherical material with about 88% aluminum and about 12% silicon in its composite ratio. It is a high conductivity metal alloy powder, and, when added to the ink formulation, it yields a dark conductive cermet.

2

# 0 125 076

The ink has the following formulation:

| Material | Range in Weight % | Optimum Weight % |
|---|---|---|
| Nickel | 34—55 | 38 |
| Aluminum | 10—14 | 12 |
| Aluminum/silicon alloy | 18—24 | 12 |
| Lead glass frit binder | 16—20 | 18 |
| Vehicle | 12—14 | 12 |

The vehicle includes a solvent such as alpha terpenol, ethyl cellulose and small quantities of lauric acid, triethanol amine and a wetting agent to control the flow properties of the ink. Other vehicle mixtures could be used.

In using the ink formulation of the invention, it is prepared and screened on a glass plate in any desired pattern. After the screening operation, the assembly is fired in air at a temperature in the range of 575°C to 585°C. The resultant conductor has a low surface resistivity of about 20 to 25 milliohms per square at a thickness of about 20 micrometres, as compared with typical aluminum and nickel surface resistivities in excess of 100 milliohms/square. The conductor is also dark in color and non-reflective so that good light contrast is achieved, and it adheres well to a support surface.

It will be clear to those skilled in the art that the glass frit of the invention is not limited to the application described and that it can be used in other applications.

## Claims

1. A glass formulation comprising PbO and $B_2O_3$, characterised in that said formulation also comprises $Cr_2O_3$, $Fe_2O_3$, and CuO.

2. A glass formulation according to Claim 1 comprising, in weight percent, about 76 PbO, about 15 $B_2O_3$, about 1 $Cr_2O_3$, about 3 $Fe_2O_3$, and about 5 CuO.

3. A glass formulation according to Claim 2 wherein the permissible variations in weight percent for each constituent are ±6 of PbO, ±4 of $B_2O_3$, up to 3 of $Cr_2O_3$, 0.5—4 of $Fe_2O_3$, and 1.5—7 of CuO.

4. An ink formulation for forming conductive elements by a screening operation including in percent by weight, nickel 34—55; aluminum 10—14; aluminum/silicon alloy 18—24; lead glass frit 16—20; and a vehicle 12—14; the lead glass frit comprising PbO and $B_2O_3$, characterised in that the frit also includes $Cr_2O_3$, $Fe_2O_3$, and CuO.

5. An ink formulation for forming conductive elements by a screening operation including in percent by weight, nickel 38; aluminum 20; aluminum/silicon alloy 12; lead glass frit 18; and a vehicle 12; the lead glass frit comprising PbO and $B_2O_3$, characterised in that the frit also includes $Cr_2O_3$, $Fe_2O_3$, and CuO.

## Patentansprüche

1. Glaszusammensetzung mit Gehalten an PbO und $B_2O_3$, dadurch gekennzeichnet, daß die Glaszusammensetzung außerdem $Cr_2O_3$, $Fe_2O_3$ und CuO enthält.

2. Glaszusammensetzung nach Anspruch 1, die, in Gewichtsprozenten, ungefähr 76 PbO, ungefähr 15 $B_2O_3$, ungefähr 1 $Cr_2O_3$, ungefähr 3 $Fe_2O_3$ und ungefähr 5 CuO umfaßt.

3. Glaszusammensetzung nach Anspruch 2, bei welcher die zulässigen Schwankungen in Gewichtsprozent für jeden Bestandteil ±6 für PbO, ±4 für $B_2O_3$, bis zu 3 für $Cr_2O_3$, 0,5 bis 4 für $Fe_2O_3$ und 1,5 bis 7 für CuO betragen.

4. Farbzusammensetzung zur Bildung leitfähiger Elemente durch ein Siebdruckverfahren, mit Gehalten von, in Gewichtsprozent, Nickel: 34 bis 55; Aluminium: 10 bis 14; Aluminium/Silizium-Legierung: 18 bis 24; Bleiglas-Frittenzusammensetzung: 16 bis 20; und ein Übertragungshilfsstoff: 12 bis 14, wobei die Bleiglas-Frittenzusammensetzung PbO und $B_2O_3$ enthält, dadurch gekennzeichnet, daß die Frittenzusammensetzung außerdem $Cr_2O_3$, $Fe_2O_3$, und CuO enthält.

5. Farbzusammensetzung zur Bildung leitfähiger Elemente durch ein Siebdruckverfahren, mit Gehalten von, in Gewichtsprozent, Nickel: 38; Aluminium: 20; Aluminium/Silizium-Legierung: 12; Bleiglas-Frittenzusammensetzung: 18; und Übertragungshilfsstoff: 12, wobei die Bleiglas-Frittenzusammensetzung PbO und $B_2O_3$ enthält, dadurch gekennzeichnet, daß die Frittenzusammensetzung weiterhin $Cr_2O_3$, $Fe_2O_3$, und CuO enthält.

3

**0 125 076**

Revendications

1. Composition de verre comprenant PbO et $B_2O_3$, caractérisée en ce qu'elle comprend aussi $Cr_2O_3$, $Fe_2O_3$ et CuO.

2. Composition de verre suivant la revendication 1, caractérisée en ce qu'elle comprend, en poids %, environ 76 PbO, env. 15 $B_2O_3$, env. 1 $Cr_2O_3$, env. 3 $Fe_2O_3$, et env. 5 CuO.

3. Composition de verre suivant la revendication 2, caractérisée en ce que les variations admissibles pour chaque constituant sont de ±6 de PbO, ±4 de $B_2O_3$, jusqu'à 3 de $Cr_2O_3$, 0,5 à 4 de $Fe_2O_3$ et 1,5 à 7 de CuO.

4. Composition d'encre pour former des éléments conducteurs par une opération d'impression au pochoir, comprenant, en pourcent en poids, nickel 34 à 55, aluminium 10 à 14, alliage aluminium-silicium 18 à 24, fritte de verre au plomb 16 à 20 et un véhicule, 12 à 14; la fritte de verre au plomb comprenant PbO et $B_2O_3$, caractérisée en ce que la fritte comprend aussi $Cr_2O_3$, $Fe_2O_3$ et CuO.

5. Composition d'encre pour former des éléments conducteurs par une opération d'impression au pochoir, comprenant en % en poids, nickel 38, aluminium 20, alliage aluminium-silicium 12, fritte de verre au plomb 18, et un véhicule 12; la fritte de verre au plomb comprenant PbO et $B_2O_3$, caractérisée en ce que la fritte contient aussi $Cr_2O_3$, $Fe_2O_3$ et CuO.

4